# EUROPEAN PATENT APPLICATION

(11) **EP 4 717 794 A1**
(43) Date of publication of application: **01.04.2026**
(21) Application number: 25175581.5
(22) Date of filing: 12.05.2025
(51) Int. Cl.: C23C 14/50, C23C 16/458

(54) **FIXING MODULE AND PROCESSING DEVICE**

(30) Priority: 27.09.2024 TW 113136823
(71) Applicant: AdNaNotek Corp., 242048 New Taipei City (TW)
(72) Inventor: YANG, KAI, Taipei City (TW)
(74) Representative: Durán-Corretjer, S.L.P.

(57) **Abstract**

A fixing module (D) and a processing device (Z) are provided. The fixing module (D) includes a first clamping component (D1), a second clamping component (D2), a fixing component (D3), a rotation component (D4), and an elastic component (D5). The first clamping component (D1) is configured to clamp an object (B). The second clamping component (D2) corresponds to the first clamping component (D1) and is configured to clamp the object (B). The fixing component (D3) corresponds to the second clamping component (D2). The rotation component (D4) corresponds to the second clamping component (D2). The elastic component (D5) is connected to the second clamping component (D2) and the fixing component (D3), and a portion of the elastic component (D5) is arranged on the rotation component (D4). The fixing module (D) is configured to pull the second clamping component (D2) through the elastic component (D5), such that a tension force is applied to the object (B) by the second clamping component (D2).

## Description

### FIELD OF THE INVENTION

The present invention relates to a fixing module and a processing device, and more particularly to a fixing module and processing device having an automatic stretching function.

### BACKGROUND OF THE INVENTION

In general coating processes, an object to be coated is fixed in place by fixing clampers. During the coating process, when the object to be coated is heated, the object will deform (such as to become longer). At this time, the object to be coated can droop downward or become corrugated, so as to result in uneven thickness of the coating.

Therefore, it has become an important issue to overcome the above-mentioned problem through improvements to the structural design of the clampers in the relevant industry.

### SUMMARY OF THE INVENTION

In response to the above-referenced technical inadequacy the present invention provides a fixing module and a processing device.

In order to solve the above-mentioned problems, one of the technical aspects adopted by the present invention is to provide a fixing module, which includes a first clamping component, a second clamping component, a fixing component, a rotation component, and an elastic component. The first clamping component is configured to clamp an object. The second clamping component corresponds to the first clamping component, and is configured to clamp the object. The fixing component corresponds to the second clamping component. The rotation component corresponds to the second clamping component. The elastic component is connected to the second clamping component and the fixing component. A portion of the elastic component is arranged on the rotation component. The fixing module is configured to pull the second clamping component through the elastic component, such that a tension force is applied to the object by the second clamping component.

In order to solve the above-mentioned problems, another one of the technical aspects adopted by the present invention is to provide a processing device, which includes a chamber module and a fixing module. An operation space is defined inside of the chamber module. The fixing module is in the operation space, and the fixing module includes a first clamping component, a second clamping component, a fixing component, a rotation component, and an elastic component. The first clamping component is configured to clamp an object. The second clamping component corresponds to the first clamping component, and is configured to clamp the object. The fixing component corresponds to the second clamping component. The rotation component corresponds to the second clamping component. The elastic component is connected to the second clamping component and the fixing component. A portion of the elastic component is arranged on the rotation component. The fixing module is configured to pull the second clamping component through the elastic component, such that a tension force is applied to the object by the second clamping component.

Therefore, in the fixing module and the processing device provided by the present invention, by virtue of the technical features set forth above, the yield and the uniformity of the coating can be improved.

These and other aspects of the present invention will become apparent from the following description of the embodiment taken in conjunction with the following drawings and their captions, although variations and modifications therein may be affected without departing from the scope of the novel concepts of the invention.

### BRIEF DESCRIPTION OF THE DRAWINGS

The described embodiments may be better understood by reference to the following description and the accompanying drawings, in which:
FIG. 1 is a schematic view of a structure of a processing device according to one embodiment of the present invention;
FIG. 2 is a functional block diagram of the processing device according to one embodiment of the present invention;
FIG. 3 is a schematic perspective view of a fixing module of the processing device according to one embodiment of the present invention;
FIG. 4 is a schematic partial enlargement view of the fixing module of the processing device according to one embodiment of the present invention;
FIG. 5 is a schematic front view of the fixing module of the processing device according to one embodiment of the present invention;
FIG. 6 is a schematic partial rear view of the fixing module of the processing device according to one embodiment of the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [Embodiment]

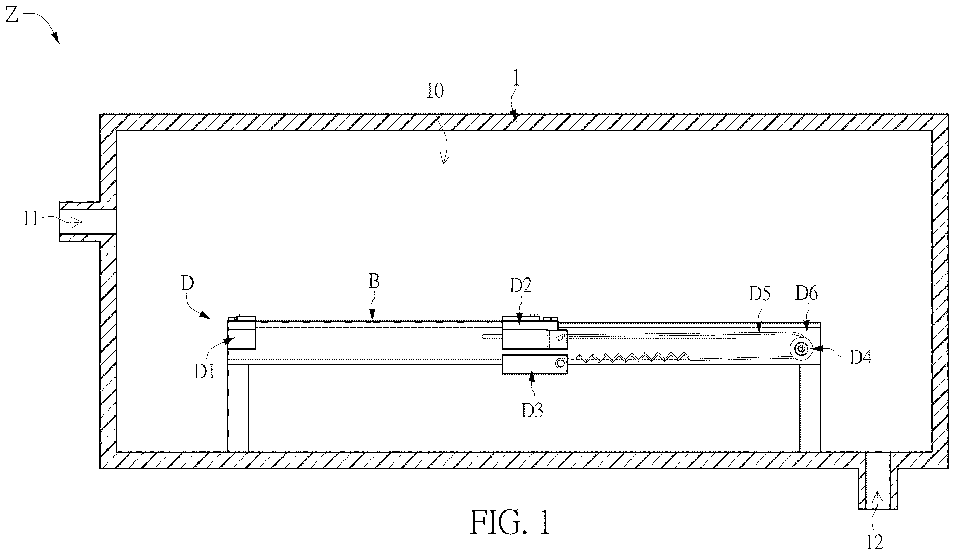

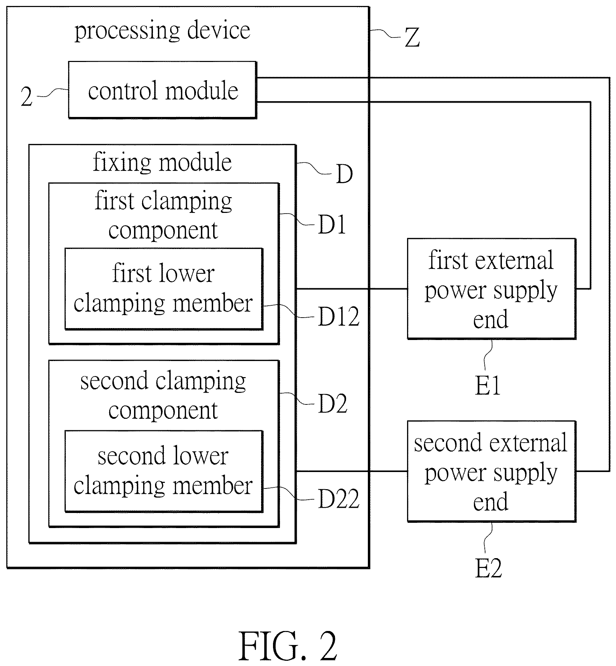

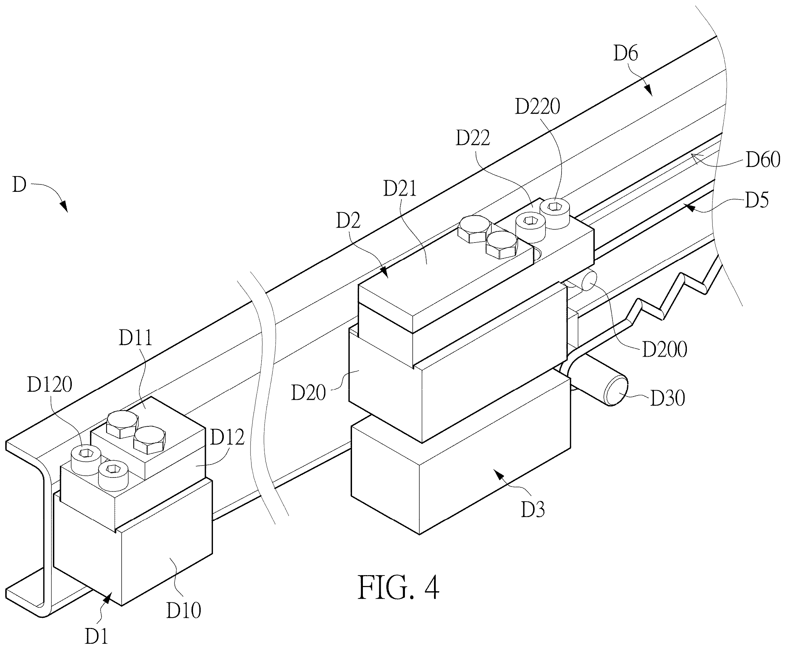

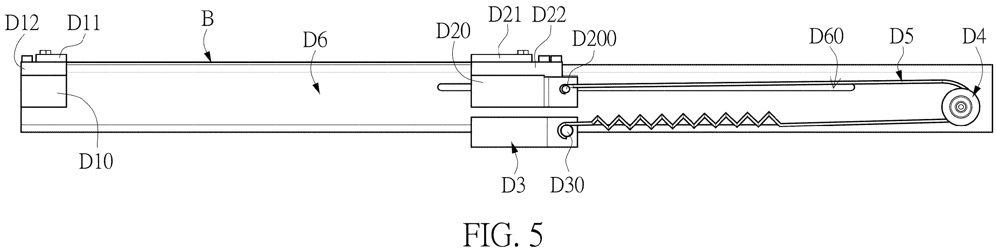

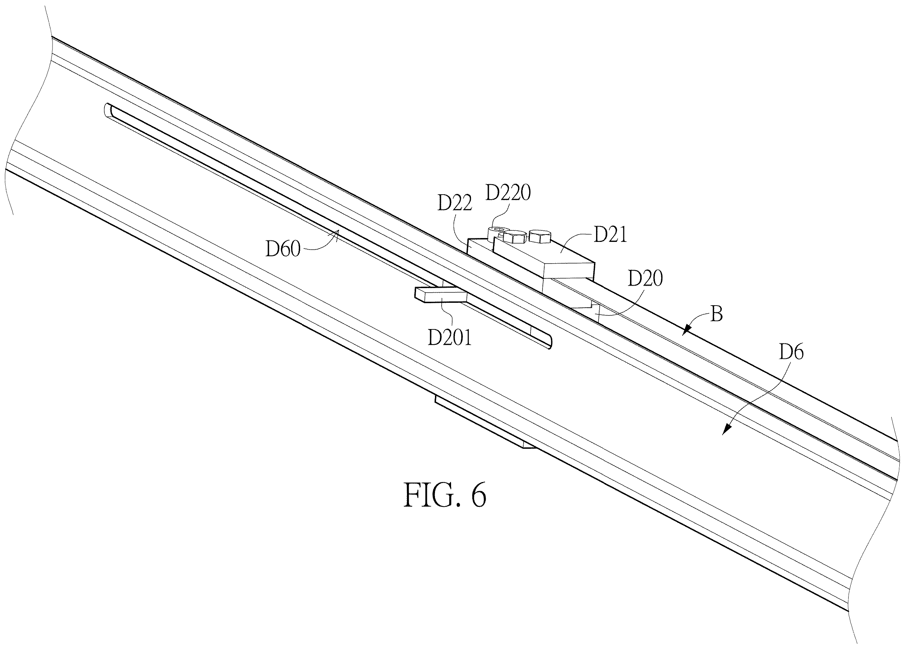

Reference is made to FIG. 1 to FIG. 6, which are a schematic view of a structure of a processing device and a functional block diagram of the processing device, and a schematic perspective view, a schematic partial enlargement view, a schematic front view, and a schematic partial rear view of a fixing module according to one embodiment of the present invention. As shown in the above figures, one embodiment of the present invention provides a processing device Z including a chamber module 1 and a fixing module D. The processing device Z can be applied to a sputtering process, but is not limited thereto. The processing device Z of the present invention can also be applied to other uses or be a processing device of other types, such as a chemical deposition device.

As shown in FIG. 1, an operation space 10 is inside the chamber module 1, and the operation space 10 is configured for accommodating the fixing module D. Furthermore, the chamber module 1 further has a gas inlet 11 and a gas outlet 12. The gas inlet 11 and the gas outlet 12 are connected to the operation space 10. The gas inlet 11 is configured to guide a specific gas (not illustrated, such as a gas for coating, but is not limited thereto). The gas outlet 12 is configured to discharge the gas in the operation space 10 (such as to vacuum the operation space 10) or discharge the specific gas mentioned above.

Then, referring to FIG. 1 to FIG. 6, the fixing module D is disposed in the operation space 10. The fixing module D includes a first clamping component D1, a second clamping component D2, a fixing component D3, a rotation component D4, and an elastic component D5.

In particular, referring to FIG. 1 to FIG. 5, the first clamping component D1 is configured to clamp an object B. For example, the first clamping component D1 includes a first seat member D10, a first upper clamping member D11, and a first lower clamping member D12. The first seat member D10 can be made from insulated or a non-conductive materials. The first upper clamping member D11 and the first lower clamping member D12 can be made from conductive materials (such as copper, but is not limited thereto). The first upper clamping member D11 is movably connected to one side of the first lower clamping member D12, and another side of the first lower clamping member D12 is connected to the first seat member D10. The first lower clamping member D12 and the first upper clamping member D11 are configured to clamp one end of the object B.

In particular, the first lower clamping member D12 further includes at least one first connector D120 (such as screws or connectors of other types), and the first lower clamping member D12 can be connected to a first external power supply end E1 (such as an external power supply supplying positive or negative power) through the first connector D120, but is not limited thereto. In other optional embodiments, the first upper clamping member D11 can alternatively be electrically connected to the first external power supply end E1.

Then, referring to FIG. 1 to FIG. 6, the second clamping component D2 corresponds to the first clamping component D1, and is configured to clamp the object B. For example, the second clamping component D2 includes a second seat member D20, a second upper clamping member D21, and a second lower clamping member D22. The second seat member D20 can be made from insulated or non-conductive materials, and one side of the second seat member D20 protrudes outward to form a first positioning portion D200. The second upper clamping member D21 and the second lower clamping member D22 can be made from conductive materials (such as copper, but is not limited thereto). The second upper clamping member D21 is movably connected to one side of the second lower clamping member D22, and another side of the second lower clamping member D22 is connected to the second seat member D20. The second lower clamping member D22 and the second upper clamping member D21 are configured to clamp another end of the object. The first clamping component D1 is disposed at one side of the second clamping component D2.

In particular, the second lower clamping member D22 further includes at least one second connector D220 (such as screws or connectors of other types), and the second lower clamping member D22 can be connected to a second external power supply end E2 (such as an external power supply supplying positive or negative power) through the second connector D220, but is not limited thereto. In other optional embodiments, the second upper clamping member D21 can alternatively be electrically connected to the second external power supply end E2.

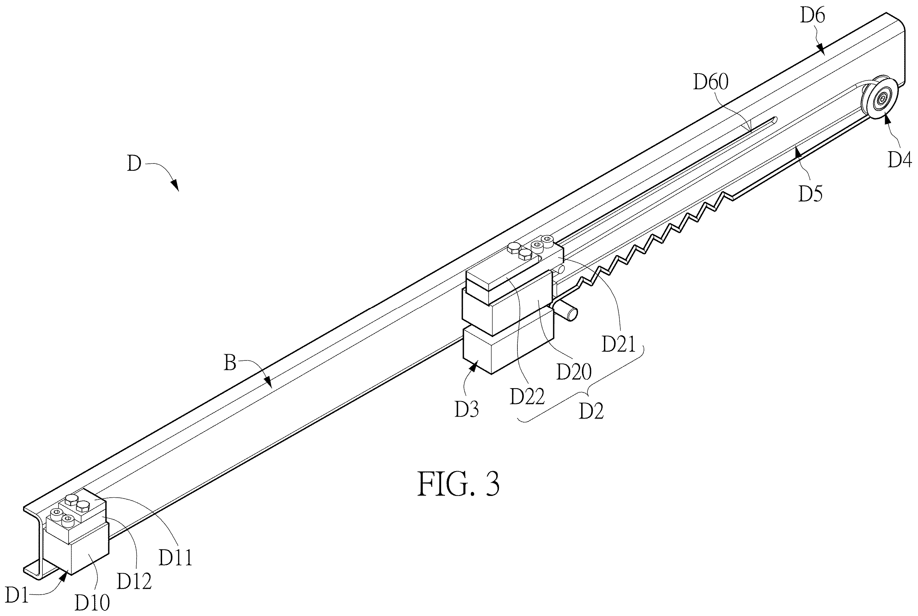

Next, referring to FIG. 3 to FIG. 5, the fixing component D3 corresponds to the second clamping component D2. For example, the fixing component D3 is disposed at one end of the second clamping component D2. The fixing component D3 can be made from insulated or non-conductive materials, and one side of the fixing component D3 protrudes outward to form a second positioning portion D30.

Next, referring to FIG. 3 to FIG. 5, the rotation component D4 corresponds to the second clamping component D2. For example, the rotation component D4 can be a pulley or a rotating wheel of other types. The rotation component D4 is disposed at another side of the second clamping component D2.

Next, referring to FIG. 3 to FIG. 5, the elastic component D5 is connected to the second clamping component D2 and the fixing component D3. A portion of the elastic component D5 is arranged on the rotation component D4. For example, the elastic component D5 can be a spring or an elastic component of other types. One end of the elastic component D5 is connected to the first positioning portion D200 of the second clamping component D2, and another end of the elastic component D5 is connected to the second positioning portion D30 of the fixing component D3. The elastic component D5 is capable of rotating the rotation component D4 around a fulcrum.

Furthermore, the fixing module D of the present invention further includes a base component D6, and the first clamping component D1, the second clamping component D2, the fixing component D3, and the rotation component D4 are disposed on the base component D6. Referring to FIG. 3 to FIG. 6, for example, the first seat member D10 is connected to the base component D6, and the second seat member D20 is movably connected to the base component D6. In particular, the base component D6 has a sliding groove portion D60, and the sliding groove portion D60 can be a sliding groove structure or a groove of other types. One side of the second seat member D20 that corresponds to the base component D6 has a slider portion D201, and the slider portion D201 is movably connected to the sliding groove portion D60.

Therefore, the fixing module D is configured to pull the second clamping component D2 through the elastic component D5, such that a tension force is applied to the object B by the second clamping component D2.

Referring to FIG. 1 to FIG. 6, for example, in applications of the processing device Z of the present invention, the object B (such as, but not limited to, a metal object to be coated) is disposed on the fixing module D, i.e., by clamping one end of the object B with the first upper clamping member D11 and the first lower clamping member D12 of the fixing module D, and clamping another end of the object B with the second lower clamping member D22 and the second upper clamping member D21 of the fixing module D. At this moment, the elastic component D5 pulls the second clamping component D2, such that a tension force is applied to the object B by the second clamping component D2.

Next, during the process of coating the object B, the power is supplied to the first clamping component D1 through the first external power supply end E1, and is also supplied to the second clamping component D2 through the second external power supply end E2, so as to heat the object B. In the process of heating the object B, the object B deforms due to being heated (such as being extended or expanded). At this moment, the second clamping component D2 is pull by a contraction force of the elastic component D5, such that the second clamping component D2 applies a tension force to the object B and tensions the object B. Therefore, during the process of coating the object B, the surface of the object B can be uniformly coated with a substance (such as a film).

In this way, by virtue of the technical features of the processing device Z of the present invention described above, the object B can be maintained in a tensioned state by the structural configuration of the fixing module D during the surface treatment process, so as to uniformly coat the surface of the object B with the substance.

Furthermore, as shown in FIG. 1 to FIG. 2, the processing device Z further includes a control module 2 electrically connected to the first external power supply end E1 and the second external power supply end E2. The control module 2 is configured to control the first external power supply end E1, the second external power supply end E2, or both, to supply or stop supplying the power to the first clamping component D1 and the second clamping component D2. For example, the control module 2 can be a processor or a terminal device (such as a computer, but is not limited thereto).

In addition, according to the above description and referring to FIG. 1 to FIG. 6, the present invention further provides a fixing module D, which includes a first clamping component D1, a second clamping component D2, a fixing component D3, a rotation component D4, and an elastic component D5. The first clamping component D1 is configured to clamp an object B. The second clamping component D2 corresponds to the first clamping component D1, and is configured to clamp the object B. The fixing component D3 corresponds to the second clamping component D2. The rotation component D4 corresponds to the second clamping component D2. A portion of the elastic component D5 is arranged on the rotation component D4. The fixing module D is configured to pull the second clamping component D2 through the elastic component D5, such that a tension force is applied to the object B by the second clamping component D2.

However, the aforementioned details are disclosed for exemplary purposes only, and are not meant to limit the scope of the present invention.

### [Beneficial Effects of the Embodiment]

In conclusion, by virtue of the technical features described above, the fixing module D and the processing device Z of the present invention can improve the yield and the uniformity of the coating.

In particular, by virtue of the technical features described above, the object B can be clamped by the fixing module D of the processing device Z of the present invention (i.e., by the first clamping component D1, the second clamping component D2, and the elastic component D5 that automatically stretches the object B to a tensioned state), such that the object B is maintained in the tensioned state during the surface treatment process, and the surface of the object B can be coated with the substance uniformly.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A fixing module (D), **characterized by** comprising:
a first clamping component (D1), wherein the first clamping component (D1) is configured to clamp an object (B);
a second clamping component (D2), wherein the second clamping component (D2) corresponds to the first clamping component (D1) and is configured to clamp the object (B);
a fixing component (D3), wherein the fixing component (D3) corresponds to the second clamping component (D2);
a rotation component (D4), wherein the rotation component (D4) corresponds to the second clamping component (D2);
an elastic component (D5), wherein the elastic component (D5) is connected to the second clamping component (D2) and the fixing component (D3), and a portion of the elastic component (D5) is arranged on the rotation component (D4);
wherein the fixing module (D) is configured to pull the second clamping component (D2) through the elastic component (D5), such that a tension force is applied to the object (B) by the second clamping component (D2).

2. The fixing module (D) according to claim 1, wherein the first clamping component (D1) is disposed on one side of the second clamping component (D2), the rotation component (D4) is disposed on another side of the second clamping component (D2), and the fixing component (D3) is disposed on one end of the second clamping component (D2).

3. The fixing module (D) according to claim 1, further comprising a base component (D6), wherein the first clamping component (D1), the second clamping component (D2), the fixing component (D3), and the rotation component (D4) are disposed on the base component (D6).

4. The fixing module (D) according to claim 3, wherein the first clamping component (D1) includes:
a first seat member (D10), wherein the first seat member (D10) is connected to the base component (D6);
a first upper clamping member (D11); and
a first lower clamping member (D12), wherein the first lower clamping member (D12) is movably connected to the first upper clamping member (D11) and is connected to the first seat member (D10), and the first lower clamping member (D12) and the first upper clamping member (D11) are configured to clamp the object (B);
wherein the second clamping component (D2) includes:
a second seat member (D20), wherein the second seat member (D20) is movably connected to the base component (D6);
a second upper clamping member (D21); and
a second lower clamping member (D22), wherein the second lower clamping member (D22) is movably connected to the second upper clamping member (D21) and is connected to the second seat member (D20), and the second lower clamping member (D22) and the second upper clamping member (D21) are configured to clamp the object (B).

5. The fixing module (D) according to claim 4, wherein the base component (D6) has a sliding groove portion (D60), the second seat member (D20) has a slider portion (D201), and the slider portion (D201) is movably connected in the sliding groove portion (D60); wherein the first upper clamping member (D11) or the first lower clamping member (D12) is electrically connected to a first external power supply end (E1), and the second upper clamping member (D21) or the second lower clamping member (D22) is electrically connected to a second external power supply end (E2).

6. A processing device (Z), **characterized by** comprising:
a chamber module (1), wherein the chamber module (1) has an operation space (10) inside;
a fixing module (D), wherein the fixing module (D) is disposed in the operation space (10), the fixing module (D) includes:
a first clamping component (D1), wherein the first clamping component (D1) is configured to clamp an object (B);
a second clamping component (D2), wherein the second clamping component (D2) corresponds to the first clamping component (D1), and is configured to clamp the object (B);
a fixing component (D3), wherein the fixing component (D3) corresponds to the second clamping component (D2);
a rotation component (D4), wherein the rotation component (D4) corresponds to the second clamping component (D2); and
an elastic component (D5), wherein the elastic component (D5) is connected to the second clamping component (D2) and the fixing component (D3), a portion of the elastic component (D5) is arranged on the rotation component (D4);
wherein the fixing module (D) is configured to pull the second clamping component (D2) through the elastic component (D5), such that a tension force is applied to the object (B) by the second clamping component (D2).

7. The processing device (Z) according to claim 6, wherein the first clamping component (D1) is disposed on one side of the second clamping component (D2), the rotation component (D4) is disposed on another side of the second clamping component (D2), and the fixing component (D3) is disposed on one end of the second clamping component (D2).

8. The processing device (Z) according to claim 6, wherein the fixing module (D) further includes a base component (D6), and the first clamping component (D1), the second clamping component (D2), the fixing component (D3), and the rotation component (D4) are disposed on the base component (D6).

9. The processing device (Z) according to claim 8, wherein the first clamping component (D1) includes:
a first seat member (D10), wherein the first seat member (D10) is connected to the base component (D6);
a first upper clamping member (D11); and
a first lower clamping member (D12), wherein the first lower clamping member (D12) is movably connected to the first upper clamping member (D11) and is connected to the first seat member (D10), and the first lower clamping member (D12) and the first upper clamping member (D11) are configured to clamp the object (B);
wherein the second clamping component (D2) includes:
a second seat member (D20), wherein the second seat member (D20) is movably connected to the base component (D6);
a second upper clamping member (D21); and
a second lower clamping member (D22), wherein the second lower clamping member (D22) is movably connected to the second upper clamping member (D21) and is connected to the second seat member (D20), and the second lower clamping member (D22) and the second upper clamping member (D21) are configured to clamp the object (B).

10. The processing device (Z) according to claim 9, wherein the base component (D6) has a sliding groove portion (D60), the second seat member (D20) has a slider portion (D201), and the slider portion (D201) is movably connected in the sliding groove portion (D60); wherein the first upper clamping member (D11) or the first lower clamping member (D12) is electrically connected to a first external power supply end (E1), the second upper clamping member (D21) or the second lower clamping member (D22) is electrically connected to a second external power supply end (E2).
